## Europäisches Patentamt
## European Patent Office
## Office européen des brevets

(19)

(11) Numéro de publication: **0 066 499**
**B1**

(12)

# FASCICULE DE BREVET EUROPEEN

(45) Date de publication du fascicule du brevet:
02.04.86

(51) Int. Cl.⁴: **H 03 H 9/08**, H 05 B 6/80

(21) Numéro de dépôt: **82400908.8**

(22) Date de dépôt: **17.05.82**

(54) **Dispositif de chauffage a micro-ondes pour resonateur haute frequence.**

(30) Priorité: **20.05.81 FR 8110006**

(43) Date de publication de la demande:
**08.12.82 Bulletin 82/49**

(45) Mention de la délivrance du brevet:
**02.04.86 Bulletin 86/14**

(84) Etats contractants désignés:
**CH DE GB LI SE**

(56) Documents cités:
**FR - A - 993 921**
**FR - A - 2 438 939**

**PROCEEDINGS OF THE TWENTY-SEVENTH ANNUAL FREQUENCY CONTROL SYMPOSIUM, 12-14 juin 1973, New Jersey, pages 199-217, Electronic Industries Association, Washington, USA, H.M. GREENHOUSE et al.: "A fast warm up quartz crystal oscillator"**

(73) Titulaire: **ETAT-FRANCAIS représenté par le DELEGUE GENERAL POUR L'ARMEMENT, Bureau des Brevets et Inventions de la Délégation Générale pour l'Armement 14, rue Saint-Dominique, F-75997 Paris Armées (FR)**

(72) Inventeur: **Decailliot, Michel M., rue du Coteau Pirey, F-25480 Miserey-Salines (FR)**
Inventeur: **Besson, Raymond M., 23, rue Octave David, F-25000 Besancon (FR)**

# Description

La présente invention a pour objet un procédé et un dispositif de chauffage pour un résonateur HF constitué par un cristal piézo-électrique qui coopère avec au moins une paire d'électrodes excitatrices produisant un champ électrique d'excitation du cristal selon une fréquence de résonance $F_Q$. Un tel résonateur est décrit par exemple dans le document FR-A 2 438 939.

On sait que la fréquence de résonance d'un résonateur à onde de volume (résonateur à quartz, cavité hyperfréquence..) dépend d'abord des dimensions du résonateur. La stabilité de la fréquence de résonance dépend donc de l'équilibre thermique du résonateur maintenu à l'aide d'un thermostat, électronique dans la plupart des cas. Lorsque le résonateur est un cristal de quartz, on peut choisir l'angle de coupe pour que la loi de variation de la fréquence en fonction de la température présente un minimum: c'est le point d'inversion des coupes AT. Le rôle d'un thermostat classique est de porter la température du cristal au voisinage de celle du point d'inversion et de la maintenir constante.

En pratique, il est toutefois particulièrement important que la mise en température du cristal piézoélectrique, c'est-à-dire le chauffage du résonateur jusqu'à une température généralement voisine de celle du point d'inversion, intervienne de façon rapide et d'une manière la plus homogène possible pour limiter les contraintes à l'intérieur du cristal.

Dans un thermostat classique, (comme le montre par exemple le brevet US-A 2 969 471) où les échanges thermiques se font par la surface, ces deux conditions s'opposent: un chauffage rapide produit des gradients de température dans le quartz (de la surface vers le centre) qui provoquent un traînage de la fréquence du résonateur. Un chauffage relativement homogène, au contraire, maintient le résonateur en équilibre et exclut toute montée rapide de température.

Pour remédier à ces inconvénients, on a déjà proposé de réaliser un chauffage interne dans la masse même de la partie active de résonateur grâce à la puissance consommée dans la résistance motionnelle du cristal. Selon ce procédé connu, il est ainsi proposé d'utiliser l'une des fréquences de résonance du cristal pour fournir au cristal une certaine puissance de chauffage interne dans la masse. Dans ce cas, le chauffage est donc produit par la vibration piézoélectrique qui utilise la résistance dynamique motionnelle d'un mode résonnant.

Bien qu'avantageux par rapport à d'autres procédés, le chauffage par mise en vibration à une fréquence de résonance du cristal ne permet d'atteindre ni une homogénéité parfaite, puisque le chauffage est produit à partir des centres de vibration, ni des vitesses de chauffage suffisantes.

La présente invention vise précisément à remédier aux inconvénients précités et à permettre de réaliser de manière simple un chauffage d'un cristal piézoélectrique qui soit à la fois ultra-rapide et parfaitement homogène.

L'invention a encore pour objet un procédé et un dispositif permettant de réguler la puissance de chauffage de manière à pouvoir maintenir un cristal piézoélectrique à une température donnée avec une dépense d'énergie minimum.

Ces buts sont atteints grâce au fait que, conformément à l'invention, on place l'ensemble du résonateur HF dans un champ supplémentaire UHF dont la fréquence F est au moins environ dix fois supérieure à la fréquence de résonance $F_Q$ du résonateur.

On relèvera que l'application d'un chauffage de type micro-ondes à la mise en température d'un cristal de quartz se heurte à de forts préjugés dans la mesure où la valeur de l'angle de perte $\delta$ du quartz est très faible (tg $\delta \simeq 2.10^{-4}$) de sorte qu'une telle application d'un chauffage par pertes diélectriques à la mise en température d'un résonateur HF peut paraître rencontrer des difficultés insurmontables.

L'invention permet toutefois de bénéficier de tous les avantages d'un chauffage par pertes diélectriques à savoir un chauffage rapide et homogène, sans que la puissance nécessaire soit prohibitive.

Ceci est rendu possible grâce à un dispositif formant thermostat chauffant qui comprend une cavité résonnante réentrante pilotant un oscillateur UHF et dimensionnée de manière à produire un champ électrique UHF de fréquence F au moins égale à environ dix fois la fréquence de résonance $F_Q$ du cristal piézoélectrique, le résonateur étant disposé dans l'espace compris entre l'âme centrale et le fond de la cavité de telle sorte que les deux électrodes du résonateur soient situées respectivement sensiblement dans les plans de l'extrémité libre de l'âme centrale et de la face interne du fond de la cavité, au moins l'une des électrodes étant disposée dans un alésage ménagé dans les parties conductrices de la cavité selon un axe sensiblement perpendiculaire au plan du cristal, la partie périphérique de l'électrode étant entourée à faible distance, mais sans contact, par la paroi dudit alésage, un conducteur interne coaxial à l'alésage et isolé de celle-ci par un garnissage de matériau isolant étant prévu pour relier l'électrode située dans le plan de l'extrémité libre de l'âme centrale à un oscillateur HF destiné à appliquer au résonateur un champ électrique de résonance à la fréquence $F_Q$.

De préférence, au moins l'électrode du résonateur située sensiblement dans le plan de l'extrémité libre de l'âme centrale est entourée à faible distance, mais sans contact par la paroi d'un alésage ménagé dans l'âme centrale et définissant une partie conductrice cylindrique externe isolée, à l'aide d'un garnissage de matériau isolant, par rapport à un conducteur interne coaxial à l'alésage et reliant ladite électrode à l'oscillateur HF destiné à appliquer au résonateur un champ électrique de résonance à la fréquence $F_Q$.

Dans ce cas, selon un mode particulier de réalisation de l'invention, l'électrode du résonateur située sensiblement dans le plan de la face interne du fond de la cavité est disposée dans un logement cylindrique ménagé dans le fond de la cavité dans le prolongement de l'âme centrale, l'arête intérieure du logement entoure sans contact mais à faible distance l'électrode située dans ledit logement, un conducteur interne coaxial à la paroi du logement cylindrique et isolé de celle-ci par un garnissage de matériau isolant, relie également l'électrode située dans ledit logement à l'oscillateur HF de manière à réaliser une excitation du résonateur qui est de type série.

Selon un autre mode de réalisation de l'invention, l'une des électrodes est constituée directement par la face terminale de l'âme centrale ou la face interne du fond de la cavité et mise à la masse de sorte qu'il est réalisé une excitation du résonateur qui est de type parallèle.

Les électrodes associées au cristal piézoélectrique peuvent être solidaires des deux faces opposées du cristal situées en regard respectivement de l'extrémité libre de l'âme centrale et du fond de la cavité.

Les électrodes associées au cristal piézoélectrique peuvent également être réalisées sous la forme de plateaux disposés à faible distance des deux faces opposées du cristal, sans contact avec celles-ci.

D'une manière générale, les espaces libres ménagés entre une électrode et la partie conductrice de la cavité qui entoure ladite électrode à faible distance, mais sans contact, définissent une impédance dont la valeur est faible vis à vis de la fréquence F du champ UHF mais forte vis à vis de la fréquence de résonance $F_Q$ du champ HF.

La fréquence F du champ électrique UHF est avantageusement comprise entre environ 500 MHz et 10 GHz.

La cavité résonnante de forme réentrante qui selon l'invention soumet un résonateur à quartz à un champ électrique micro-onde intense et uniforme tout en permettant au résonateur à quartz de recevoir indépendamment le champ électrique excitant sa propre résonance, assure dans tous les cas un chauffage au niveau moléculaire qui est indépendant de la conductibilité du quartz. Le four micro-onde que constitue la cavité résonnante permet de chauffer des résonateurs à quartz fonctionnant dans la gamme de fréquences $F_Q$ comprise entre environ 1 et 500 MHz.

Le dispositif selon l'invention apporte ainsi une solution notamment au chauffage des résonateurs à quartz embarquables, qui doit pouvoir être le plus rapide possible, et au chauffage des résonateurs à quartz de type métrologique qui doit pouvoir être le plus homogène possible pour éviter un effet d'hystérésis de fréquence. L'invention trouve également un vaste champ d'application dans le chauffage des horloges à quartz à fonctionnement intermittent équipant des appareils de mesure de grande précision tels que par exemple les fréquencemètres, calculateurs, analyseurs de spectres.

Selon une disposition particulièrement avantageuse de la présente invention, le dispositif de chauffage comprend en outre des moyens de modulation de la fréquence F du champ électrique UHF, des moyens de détection de la modulation induite sur la fréquence de résonance $F_Q$ du cristal et des moyens d'asservissement de la fréquence F du champ électrique UHF en fonction du signal de modulation détecté par lesdits moyens de détection pour maintenir le signal de modulation détecté en-dessous d'un niveau prédéterminé et réaliser ainsi une régulation de la température du cristal.

Le thermostat chauffant selon l'invention permet ainsi de mettre en œuvre un procédé de régulation particulièrement utile lorsqu'il s'agit notamment de réaliser des résonateurs présentant une fréquence de résonance très stable.

D'autres caractéristiques et avantages de l'invention ressortiront de la description de modes particuliers de réalisation, faite en référence au dessin annexé, sur lequel:

– la figure 1 est une vue schématique en coupe axiale d'un dispositif de chauffage selon l'invention constitué par une cavité résonnante réentrante adaptée à un résonateur à électrodes non adhérentes au cristal,

– la figure 2 est une vue schématique partielle en coupe axiale d'une variante du dispositif de la figure 1, adaptée à un résonateur à électrodes adhérentes au cristal,

– la figure 3 est une vue schématique partielle en coupe axiale montrant une autre variante du dispositif de la figure 1 adaptée à un résonateur à excitation parallèle,

– la figure 4 est une représentation schématique d'une cavité résonnante classique, et

– les figures 5a à 5c sont des diagrammes montrant des courbes donnant la fréquence de résonance $F_Q$ du résonateur en fonction de la température et l'influence d'une modulation de la fréquence du champ électrique micro-ondes.

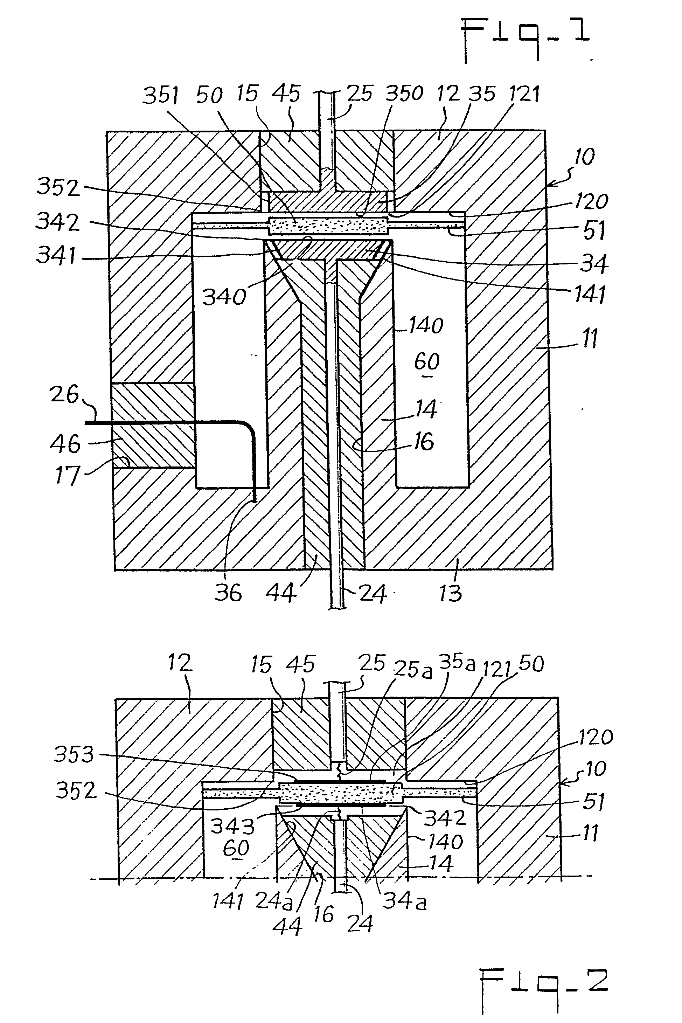

La figure 1 montre la représentation schématique et agrandie d'un four micro-onde selon l'invention destiné à assurer le chauffage et le maintien à une température déterminée d'un résonateur HF à cristal piézoélectrique.

Le four micro-onde comprend essentiellement une cavité réentrante 10 qui constitue un circuit résonnant. Le cristal de quartz 50 qui constitue l'élément actif vibrant du résonateur HF est lui-même disposé dans l'espace libre, encore appelé «gap», situé entre l'âme centrale 14 et le fond 12 de la cavité 10.

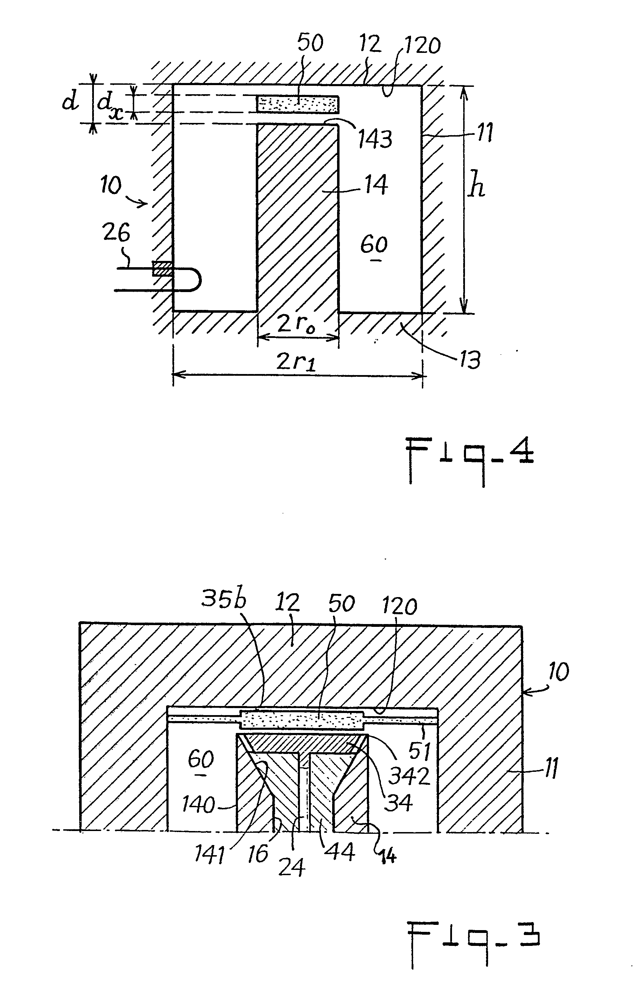

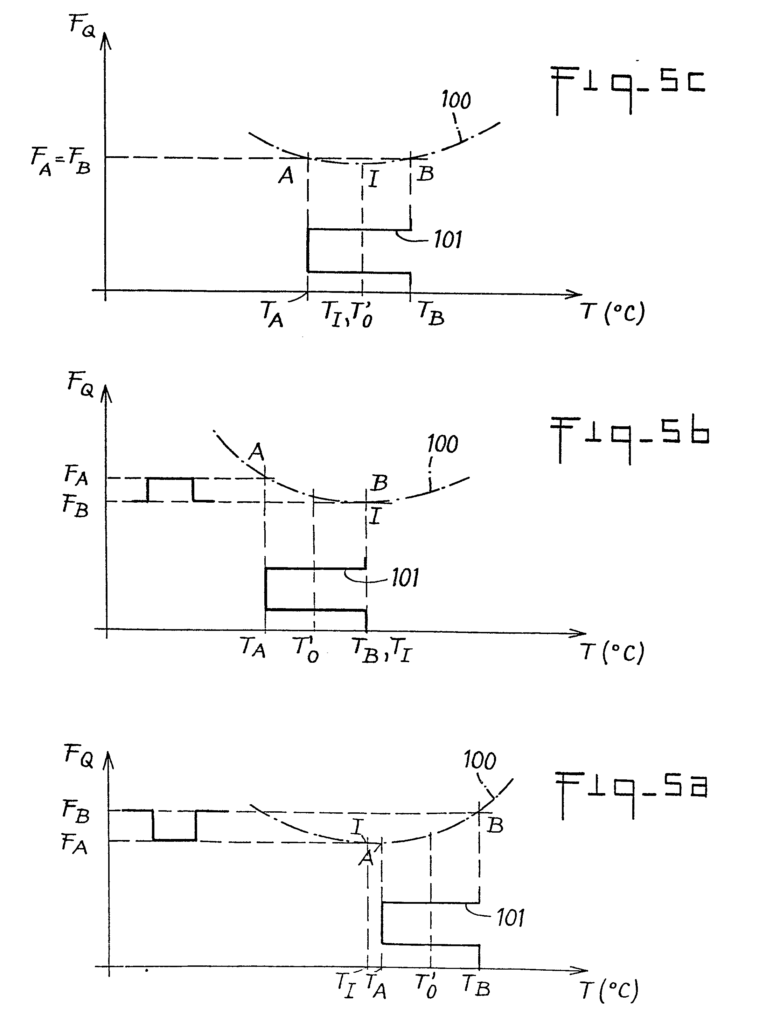

La figure 4 représente de façon schématique une cavité réentrante 10 classique qui comprend une structure extérieure métallique composée d'une partie latérale cylindrique 11, d'une première partie frontale 12 définissant le fond de la cavité et d'une deuxième partie frontale 13 qui se prolonge par une âme centrale cylindrique pleine 14 qui pénètre dans l'espace libre interne 60 de la cavité en restant coaxiale à la partie latérale cylindrique externe 11. L'âme centrale 14 raccordée à la partie 13 se termine du côté opposé par une extrémité libre 143, située à faible distance du fond 12 de la cavité. L'espace libre entre la face terminale 143 de l'âme centrale 14 et la paroi interne 120 du fond 12 de la cavité est le siège d'un champ électrique normal à la face 143 et à la paroi du fond 12.

La cavité réentrante 10 de la figure 4 constitue ainsi une portion de ligne coaxiale fermée avec un conducteur extérieur 11 et un conducteur central 14. Ce dernier qui est interrompu à une de ses extrémités définit une première armature 143 tandis que la partie supérieure 12 de la cavité qui constitue une extrémité de la ligne coaxiale forme avec sa partie interne 120 une deuxième armature 120 reliée électriquement au conducteur extérieur 11. Le champ électrique est radial dans l'espace interne de la cavité réentrante situé entre le conducteur central 14 et le conducteur extérieur 11, tandis que dans l'espace libre compris entre l'armature inférieure 143 et l'armature supérieure 120 de l'extrémité de la ligne 12 formant un fond ou un couvercle pour la cavité réentrante, le champ électrique est normal aux armatures. La cavité réentrante 10 est encore équipée d'une ou plusieurs boucles de couplage disposées à sa partie inférieure, reliées à un oscillateur UHF, et permettant de produire une résonance dans la cavité. La courbe de résonance correspond à une plage de fréquences dont les valeurs sont déterminées par les caractéristiques géométriques de la cavité 10. Par ailleurs, le champ électrique UHF produit dans la cavité est concentré, sous une forme très homogène, pour environ 80% dans l'espace inter-armatures compris entre les armatures 143 et 120.

Une cavité réentrante 10 se comporte ainsi comme un circuit résonnant et les éléments r, L, C du circuit électrique équivalent peuvent être évalués en fonction des dimensions géométriques de la cavité à l'aide des formules suivantes établies par FUJISAWA:

$$L = (2\pi)^{-1}\, \mu_o\, h\, \text{Log}\, \frac{r_1}{r_o} \qquad (1)$$

$$C = \frac{\varepsilon_o\, \pi\, r_o^2}{\Delta + d_x\, \varepsilon_r^{-1}} \quad (2) \qquad (\Delta = d - d_x)$$

$$r = \frac{1}{2\pi\delta\Delta}\left(\frac{h-d}{r_o} + \frac{h}{r_1} + 2\, \text{Log}\, \frac{r_1}{r_o}\right) \qquad (3)$$

où $\delta$ représente la profondeur de l'effet de peau, V la conductivité électrique des parois, $r_o$ représente le rayon de l'âme centrale 14, $r_1$ représente le rayon de la paroi interne du conducteur extérieur 11, h représente la distance entre les faces internes des parties frontales 12 et 13, d représente la distance entre les armatures 143 et 120, $d_x$ représente l'épaisseur de l'élément diélectrique 50 disposé entre les armatures 143 et 120, $\mu_o$ est la perméabilité magnétique du vide, $\varepsilon_o$ est la permittivité diélectrique du vide et $\varepsilon_r$ est la constante diélectrique de l'élément diélectrique 50 (cristal de quartz).

La fréquence F de la cavité ainsi que son coefficient de qualité Q peuvent alors être facilement déterminés. A titre d'exemple:

| $r_o$ (m) | $r_1$ (m) | h (m) | d (m) | F (GHz) | r ($\Omega$) | Q |
|---|---|---|---|---|---|---|
| $2{,}5.10^{-3}$ | $6{,}5.10^{-3}$ | $13.10^{-3}$ | $0{,}1.10^{-3}$ | 5 | 0,02 | 2.100 |

Selon l'invention, on utilise ainsi une cavité réentrante 10 pour produire un champ électrique micro-onde dont la fréquence F est très supérieure à la fréquence de résonance $F_Q$ du résonateur HF que l'on désire chauffer. Le résonateur HF peut ainsi être introduit dans l'espace interarmatures compris entre la partie terminale 143 de l'âme centrale 14 et la face interne 120 du fond 12 de la cavité, et soumis à un champ électrique micro-onde (par exemple de l'ordre de 3 GHz) intense et homogène qui n'excite pas de vibration piézoélectrique dans le cristal de quartz du résonateur HF du fait même de la grande différence entre la fréquence de résonance $F_Q$ du cristal et la fréquence F du champ micro-onde. Ainsi, la fréquence F du champ électrique micro-onde doit être d'au moins environ dix fois supérieure à la fréquence de résonance $F_Q$ du cristal 50 pour éviter tout couplage.

Du fait même que la fréquence F du champ électrique UHF chauffant n'interfère pas avec l'effet piézoélectrique dans le cristal 50, puisqu'elle n'est pas résonnante pour ce cristal, le chauffage peut s'effectuer intégralement par l'effet de polarisation du diélectrique. On sait en effet que la molécule d'un diélectrique placé dans un champ électrique acquiert un moment électrique (polarisation) plus ou moins important. L'application d'un champ alternatif provoque un basculement continuel des charges électriques produisant une dissipation d'énergie électrique qui apparaît sous forme de chaleur. Le dégagement se produit dans toute la masse indépendamment de toute conductibilité thermique, ce qui assure une excellente homogénéité.

L'angle de perte $\delta$ qui est une donnée liée à la nature du matériau diélectrique caractérise, avec la fréquence F du champ électrique l'aptitude du matériau à dissiper de la chaleur, et définit avec la fréquence F du champ électrique le rendement du chauffage. On a ainsi:

$$\frac{P_c}{P_{em}} = 2\,\pi\, F.\text{tg}\delta \qquad (4)$$

où F est la fréquence du champ électrique,
$\delta$ est l'angle de perte du matériau diélectrique,
$P_{em}$ est la puissance emmagasinée par cycle,
$P_c$ est la puissance moyenne dissipée dans le diélectrique.

Par ailleurs, la puissance complexe $\overline{P_G}$ fournie au circuit d'application du champ électrique s'exprime par:

$$\overline{P_G} = P_c - 2j\omega P_{em} \qquad (5)$$

avec $\omega = 2 \pi F$.

Dans le cas où le champ électrique micro-onde de chauffage est appliqué aux armatures d'un condensateur qui contient un résonateur HF, et pour lequel les armatures coïncident avec les électrodes du résonateur HF, le rendement $\rho$ entre la puissance $\overline{P_G}$ fournie par le générateur UHF et la puissance $P_c$ dissipée dans le cristal du résonateur HF peut être exprimé avec une bonne approximation par la formule suivante:

$$\rho = \frac{P_c}{|P_G|} = tg\delta \qquad (6)$$

Dans le cas d'un cristal de quartz pour lequel $tg\delta \simeq 2.10^{-4}$, le rendement $\rho$ reste ainsi très faible.

Dans le cadre de la présente invention, le champ électrique micro-onde de chauffage est toutefois appliqué par l'intermédiaire d'une cavité résonante 10. Ainsi, le condensateur constitué par le résonateur HF est incorporé dans le circuit résonnant série défini par la cavité résonnante, ce qui permet de bénéficier d'une surintensité $I_o$ à la résonance, qui est liée au coefficient de surtension de la cavité.

Si $Q_o$ est le coefficient de surtension de la cavité résonnante sans diélectrique, Q le coefficient de surtension de la cavité résonnante lorsqu'un diélectrique tel que le cristal 50 y est incorporé, le rendement $\rho$ s'exprime alors par:

$$\rho = \frac{P_c}{P_G} = Q\ tg\delta \simeq Q_o\ tg\delta \qquad (7)$$

La mise en œuvre d'une cavité résonnante permet ainsi de multiplier le rendement par un facteur Q qui peut être facilement de l'ordre de $10^3$ pour une cavité de qualité ordinaire.

Dans ces conditions, et malgré la faible valeur de $tg\delta$ pour un matériau comme le quartz, il est possible d'obtenir un rendement $\rho$ qui est par exemple de l'ordre de 0,2. Par suite, une puissance $P_G$ modérée de l'ordre de 1 w permet de disposer d'une puissance $P_c$ de chauffage de l'ordre de 200 mW.

Or, il a été établi que pour un résonateur HF, la vitesse d'élévation de la température du quartz est donnée par la relation suivante:

$$v = \frac{P_c}{CV}\ ^oK/_{seconde} \qquad (8)$$

où $P_c$ est la puissance de chauffage, C est la chaleur spécifique volumique du quartz, V est le volume du cristal de quartz.

Par ailleurs, la puissance d'entretien $P_c$ nécessaire pour compenser les transferts de chaleur du cristal de quartz vers le milieu ambiant, qui s'effectuent essentiellement par radiation, peut s'exprimer par:

$$P_c = C_r\ (T_q - T_a) \qquad (9)$$

où $C_r$ est la conductibilité du quartz
$T_q$ est la température du cristal de quartz
$T_a$ est la température ambiante.

On peut déduire des relations (8) et (9) qu'avec une puissance $P_G$ modérée de 1 W et pour un cristal de quartz de volume V moyen (par exemple $V = 9\ mm^3$), une vitesse de chauffage de l'ordre de 1°K/seconde peut être obtenue sans difficulté de même qu'ensuite un maintien du cristal à une température prédéterminée malgré les pertes par radiation, la puissance d'entretien $P_e$ pouvant être de l'ordre de 80 mW pour le maintien à une température différent de quelques dizaines de degré par rapport à la température ambiante et naturellement bien inférieure si des précautions particulières sont prises pour isoler thermiquement le résonateur. Or, comme cela a été indiqué précédemment, une puissance de 1 W fournie par un oscillateur UHF permet d'appliquer une puissance de chauffage qui peut être par exemple de l'ordre de 200 mW, et se trouve ainsi largement supérieure aux puissances de chauffage souhaitables pour réaliser un chauffage ultra rapide d'un cristal et ensuite le maintien de ce cristal à une température prédéterminée, telle que sa température d'inversion qui peut être par exemple de l'ordre de 65 °C.

On décrira maintenant en référence aux figures 1 à 3 la structure particulière de la cavité résonnante 10 adaptée de manière à permettre non seulement l'application du champ électrique de chauffage micro-onde, mais également l'application d'un champ électrique HF au résonateur incorporé dans la cavité 10.

La cavité résonnante 10 de la figure 1 est conforme au schéma de la figure 4 dans la mesure où elle présente un boîtier cylindrique conducteur 11, deux faces frontales 12 et 13, une âme centrale 14 comprenant une partie cylindrique extérieure conductrice 140 interrompue à distance de la face interne 120 du fond 12 et une boucle de couplage 26 dont une extrémité engagée dans un alésage 17 de la paroi latérale 11 de la cavité et isolée de celle-ci par un matériau électriquement isolant 46 est reliée à un oscillateur UHF, non représenté, et l'autre extrémité 36 est reliée à la masse par le fond 13 de la cavité 10. Un cristal piézoélectrique 50 est en outre disposé dans l'espace situé entre l'extrémité libre de l'âme centrale 14 et le fond 12 de la cavité, comme si la cavité 10 devait servir à exciter une vibration piézoélectrique du cristal 50. Toutefois, l'épaisseur du cristal 50 utilisé dans le cadre de la présente invention est naturellement bien supérieure à celle d'un cristal prévu pour résonner à une très haute fréquence, puisque le cristal 50 doit faire partie d'un résonateur HF et n'est placé dans une cavité résonnante que pour des besoins de chauffage.

La cavité 10 de la figure 1 diffère cependant de la cavité de la figure 4 sur un point essentiel. Ainsi, dans le cas de la figure 1, la cavité conductrice 10 qui est de révolution est percée de part en part dans sa partie centrale de manière à définir deux alésages axiaux 15, 16 d'une part dans le fond 12 de la cavité et d'autre part, dans l'âme centrale 14 et la deuxième partie frontale 13, de part et d'autre du cristal 50. Deux électrodes 34, 35 sont introduites dans les alésages 16 et 15 respectivement et présentent une surface 340, 350 respectivement qui se trouve en regard de la partie active du cristal, sans contact avec le cristal, mais à faible distance de celui-ci. Ces électrodes 34, 35 permettent d'appliquer au cristal 50 le champ électrique HF nécessaire pour exciter une vibration piézoélectrique utile à celui-ci à une fréquence de résonance $F_Q$. La distance entre les surfaces 340 et 350 est donc adaptée en fonction du choix de la fréquence $F_Q$.

La configuration géométrique de la cavité résonnante 10 est toutefois établie de telle manière que les surfaces 340 et 350 des électrodes 34 et 35 se trouvent sensiblement dans le même plan que, respectivement, l'extrémité libre 342 de la partie conductrice extérieure 140 de l'âme 14 et la surface interne 120 du fond 12 de la cavité.

Les électrodes 34, 35 sont connectées à des conducteurs centraux 24, 25 introduits dans les alésages 16, 15 respectivement. Des garnissages 44, 45 d'un matériau isolant sont introduits dans les alésages 16, 15 respectivement de manière à isoler les conducteurs 24, 25 des parties conductrices 140, 13 et 12 de la cavité 10. Les conducteurs 24, 25 permettent de relier les électrodes 34, 35 à un oscillateur HF extérieur non représenté, afin d'apporter l'énergie nécessaire à la création du champ électrique d'excitation à la fréquence de résonance $F_Q$.

Selon une caractéristique importante de l'invention, les faces latérales périphériques 342, 352 des plateaux définissant les électrodes 34, 35 respectivement sont sans contact avec les parois conductrices des alésages 16, 15 respectivement, mais situées à faible distance de ces dernières de telle manière qu'il soit défini entre les électrodes 34, 35 et les parois de la cavité 10 qui sont en regard de celles-ci des capacités dont l'impédance est faible pour les très hautes fréquences du domaine des micro-ondes mais forte pour le domaine des hautes fréquences auquel appartient la fréquence $F_Q$ de résonance du cristal piézoélectrique 50. De la sorte, l'application du champ électrique HF à la fréquence $F_Q$ pour les électrodes 34, 35 peut bien être effectuée sans que les parties conductrices 140, 12, voisines amènent de perturbation de ce champ électrique HF. De même, le fait que les coupures réalisées entre les parties conductrices 140, 12 respectivement et les électrodes 34, 35 présentent une épaisseur relativement faible permet aux électrodes 34, 35 de jouer un double rôle et d'assurer également l'application du champ électrique UHF dans l'espace où se trouve disposé le cristal piézoélectrique 50. La coupure 121 située entre l'arête 351 de l'alésage 15 et la surface 350 de l'électrode 35 n'est en effet pas opérante vis à vis des ultra hautes fréquences. De même, la coupure réalisée entre l'extrémité libre terminale 342 de la partie conductrice extérieure 140 de l'âme centrale 14 et la surface 340 de l'électrode 34 est inopérante vis à vis des fréquences du champ électrique UHF. Vis à vis de l'application du champ électrique micro-onde tout se passe donc comme si la cavité 10 de la figure 1 avait bien la structure schématisée sur la figure 4.

Le cristal piézoélectrique 50 est de préférence du type comprenant une partie centrale active disposée en regard des électrodes 34, 35 et une partie périphérique de support 51 qui permet de suspendre le cristal 50 entre le fond 12 et l'âme centrale 14 de la cavité réentrante 10. Le cristal 50 peut par exemple être supporté par encastrement de la partie périphérique 51 dans la paroi latérale cylindrique 11 de la cavité réentrante 10. La partie périphérique 51 pourrait aussi reposer sur un bloc diélectrique disposé dans l'espace libre annulaire 60 de la cavité entre l'âme centrale 14 et la paroi latérale 11. La présence d'un matériau diélectrique dans l'espace annulaire 60 permet de former un support pour la partie périphérique 51 et permet également de réduire les dimensions de la cavité (à fréquence F constante) dans un souci de miniaturisation.

Selon une forme particulière d'exécution, la partie conductrice externe 140 de l'âme centrale 14 présente une partie supérieure amincie, l'alésage axial 16 se terminant par une portion 141 évasée de forme tronconique dont la grande base 342 constitue l'extrémité libre de la partie conductrice externe 140. Dans ce cas, l'électrode 34 présente elle-même une forme tronconique, la tranche 341 de l'électrode 34 étant située à faible distance de la partie supérieure 141 de l'alésage 16, mais sans contact avec cette partie supérieure 141. Cette configuration permet de prolonger la partie conductrice externe 140 jusque dans le plan 340 de la surface de l'électrode 34 faisant face au cristal 50, sans que la portion terminale de la partie 140 qui entoure l'électrode 34 soit trop fragilisée.

La figure 2 représente un autre mode de réalisation selon lequel il est mis en œuvre un résonateur HF à électrodes 34a, 35a adhérentes au cristal. Selon ce mode de réalisation, les électrodes 34a, 35a sont déposées directement sur les deux faces opposées du cristal 50, d'une manière connue en soi, de manière à définir un résonateur dont la fréquence de résonance dépend de l'épaisseur du cristal. Le cristal 50 est positionné par rapport à la cavité 10 par sa partie périphérique 51 de telle manière que les électrodes 34a, 35a se trouvent à la fois en regard des alésages 16, 15 respectivement ménagés comme dans le cas de la figure 1 dans l'âme 14 et le fond 12 respectivement, et sensiblement dans le plan de l'extrémité libre 342 de la partie extérieure 140 de l'âme 14 et dans le plan de la face intérieure 120 du fond 12 respectivement. Les éléments similaires dans les modes de réalisation des figures 1 et 2 portent les mêmes références numériques.

Ainsi, les alésages 16, 15 de la figure 2 comprennent comme dans le cas de la figure 1 des garnitures 44, 45 de matériau isolant qui créent une isolation électrique entre les parties conductrices 140, 12 de la cavité 10 et les conducteurs axiaux 24, 25 qui relient les électrodes 34a, 35a à un oscillateur HF. Dans le cas du dispositif de la figure 2, le matériau isolant des garnitures 44, 45 présente une surface libre qui est située un peu en retrait par rapport aux arêtes respectives 342, 352 des alésages 16, 15 de manière à éviter tout contact entre les électrodes 34a, 35a solidaires du cristal et donc vibrantes, et le matériau isolant. Les conducteurs 24, 25 sont eux-mêmes connectés aux électrodes 34a, 35a par de petits fils conducteurs souples 24a, 25a qui n'apportent pas d'entrave aux vibrations des électrodes 34a, 35a.

Comme dans le cas de la figure 1, les espaces libres entre la périphérie 343, 353 des électrodes 34a, 35a et les arêtes 342, 352 sont d'une dimension telle qu'ils définissent des capacités dont l'impédance est faible pour les très hautes fréquences du domaine des micro-ondes mais forte pour le domaine des hautes fréquences. De la sorte, l'application du champ électrique haute fréquence par les électrodes 34a, 35a reliées par les conducteurs 24, 25 à l'oscillateur HF peut se faire aisément et le champ électrique UHF peut également être appliqué par l'intermédiaire des électrodes 34a, 35a qui, pour les très hautes fréquences, forment une continuité avec les parties conductrices 140 et 120 respectivement. Le mode de réalisation de la figure 2 peut cependant être considéré comme un peu moins performant que celui de la figure 1, dans la mesure où les électrodes 34a, 35a liées à la partie active du cristal 50 vibrent également à la fréquence de résonance $F_Q$ du cristal et peuvent donc perturber légèrement le champ électrique micro-ondes. L'efficacité du champ électrique micro-ondes n'en est toutefois pas réellement affectée puisque le champ électrique d'excitation du cristal reste toujours à un niveau relativement faible.

La figure 3 présente une variante du mode de réalisation de la figure 1, cette variante étant adaptée à un résonateur HF à excitation parallèle par opposition aux modes de réalisation des figures 1 et 2 adaptés à des résonateurs HF du type à excitation série. Sur la figure 3, l'âme centrale 14 et l'électrode inférieure 34 sont tout à fait conformes à la description faite en référence à la figure 1. En revanche, sur la figure 3, la partie formant la deuxième électrode 35b est constituée directement par la face interne 120 du fond 12 de la cavité 10 et cette face interne 120 ne présente aucune discontinuité. Comme dans le cas des modes de réalisation des figures 1 et 2, la partie 35b jouant le rôle d'électrode pour le cristal 50 contribue à l'application d'une part du champ électrique HF et d'autre part du champ électrique UHF. L'absence de conducteur indépendant pour l'électrode 35b qui est ainsi non isolée électriquement du fond 12, implique simplement que l'électrode 35b est mise à la masse par le boîtier de la cavité résonnante 10, l'électrode 34 restant reliée à un oscillateur HF. Ainsi, le mode de réalisation de la figure 3 correspond à un résonateur HF à excitation parallèle qui peut donc être utilisé en combinaison avec une cavité réentrante de chauffage micro-onde 10 comme les résonateurs HF à excitation série des modes de réalisation des figures 1 et 2.

Il sera maintenant décrit en référence aux fig. 5a à 5c un procédé de régulation de la température d'un cristal de quartz 50 disposé dans un dispositif conforme à l'invention tel que celui des figures 1 à 3.

Comme cela a été indiqué plus haut (relation 4), pour un cristal 50 donné et une cavité réentrante 10 donnée, la puissance de chauffage $P_c$ fournie au cristal 50 par le champ électrique UHF de la cavité réentrante 10 est proportionnelle à la fréquence F de l'oscillateur UHF piloté par la cavité 10. La fréquence de résonance $F_Q$ du cristal 50 est elle-même dépendante de la température interne du cristal 50, et donc de la puissance de chauffage $P_c$. Il est ainsi possible d'utiliser le signal HF délivré par le résonateur comme information relative à la température du cristal et par suite de réaliser un asservissement de la fréquence de l'oscillateur hyperfréquence sur une température prédéterminée du cristal telle que la température d'inversion. Pour cela, on module la fréquence de l'oscillateur hyperfréquence en modulant la fréquence de résonance de la cavité 10 à l'aide d'une fréquence modulante par ex. sinusoïdale, qui peut être de l'ordre de 10 à 1000 Hz et qui présente une pulsation $\Omega$. Si $\Delta F$ représente l'excursion de fréquence et $\omega$ la pulsation du champ électrique UHF, il vient:

$$\omega = 2\pi (F + \Delta F \sin \Omega t) \qquad (10)$$

La puissance de chauffage $P_c$ qui est proportionnelle à $\omega$ est elle-même modulée. Ainsi, en régime dynamique, le cristal 50 emmagasine de la chaleur avec une constante de temps $\tau_1$, qui dépend de $\omega$ et peut être aussi courte qu'à environ 1 milliseconde, et restitue de la chaleur à l'environnement ambiant avec une constante de temps $\tau_2$ normalement supérieure à environ 1 seconde, et qui peut être très supérieure en fonction de l'isolement du dispositif de chauffage par rapport à l'environnement ambiant.

Si $T_{qo}$ désigne la température du cristal à l'équilibre thermique statique, cette température devenant $T_q$ au moment où la pulsation $\omega$ de la fréquence UHF est modulée, si $\theta$ est la période de la modulation, et si $T_a$ est la température ambiante, on peut établir la relation suivante:

$$\frac{T_q - T_a}{T_{q_o} - T_a} = \frac{\Delta F}{F} \cdot \frac{\tau 2}{\theta} \qquad (11)$$

$\frac{\theta}{\tau 2}$ étant dans tous les cas très inférieure à l'unité.

Les figures 5a à 5c montrent en trait mixte une courbe 100 donnant pour un cristal de quartz déterminé, par exemple un cristal de quartz de coupe AT, la fréquence de résonance $F_Q$ du cristal

en fonction de sa température interne T en °celsius. La courbe 100 présente un minimum ou point d'inversion I correspondant à une température prédéterminée, par exemple de 65°C.

Lorsque la fréquence de l'oscillateur hyperfréquence est modulée à une fréquence $\Omega$, par une modulation en créneaux, la puissance de chauffage $P_c$ est modulée de la même manière et la température T du cristal évolue autour d'un point de la courbe 100, correspondant à une température $T'_o$, entre deux points A et B. Il s'ensuit que la fréquence $F_Q$ du cristal de quartz est elle-même modulée lorsque la température T oscille entre la température du point A et la température du point B par suite de la modulation de la puissance de chauffage (Fig. 5a et 5b). Ainsi, sur la fig. 5a la température $T_A$ du point A et la température $T_B$ du point B sont toutes deux supérieures à la température d'inversion $T_I$ du cristal. Du fait que la température moyenne $T'_o$ est supérieure à la température d'inversion $T_I$, la fréquence $F_B$ correspondant au point B est supérieure à la fréquence $F_A$ correspondant au point A. Sur la figure 5b, la température $T'_o$ est inférieure à la température d'inversion $T_I$. La fréquence $F_A$ est alors devenue supérieure à la fréquence $F_B$. Quant à la fig. 5c, pour laquelle la température $T'_o$ correspond à la température d'inversion $T_I$, elle montre que les points A et B sont symétriques par rapport au point d'inversion I et que la fréquence $F_A$ est égale à la fréquence $F_B$.

Grâce à la modulation de la fréquence de l'oscillateur hyperfréquence, et en faisant varier légèrement la fréquence hyperfréquence de base, il est ainsi possible, par la détection du signal $F_Q$ modulé fourni par le résonateur HF, de détecter un changement de phase de ce signal modulé et d'asservir la fréquence de l'oscillateur hyperfréquence de telle manière que les ordonnées $F_A$ et $F_B$ des points A et B soient égales. On est ainsi au point d'équilibre de l'asservissement et la température du cristal peut être maintenue à la température d'inversion avec une dépense d'énergie minimale et avec la garantie d'une stabilité excellente pour la fréquence de résonance $F_Q$ du résonateur HF.

Si l'on considère à nouveau la formule (11) donnée précédemment, on peut considérer deux cas possibles. Dans le premier cas, le rapport

$$R = \frac{Tq - T_a}{Tq_o - T_a}$$

est voisin de l'unité. Cette condition correspond à un résonateur à quartz peu isolé, et des valeurs par exemple telles que $\tau_2 = 1$ seconde, $\theta = 10^{-3}$ seconde, $\Delta F = 3.10^6$ Hz, ou encore à un résonateur à quartz relativement bien isolé avec par exemple des valeurs telles que $\tau_2 = 100$ secondes, $\theta = 10^{-2}$ seconde, $\Delta F = 3.10^5$ Hz. Dans ce cas, il est possible de réaliser une régulation de la température du cristal de la manière décrite précédemment en exploitant la loi de variation dynamique fréquence-température.

Dans le second cas, le rapport

$$R = \frac{Tq - T_a}{Tq_o - T_a}$$

est très supérieur à l'unité. Cette condition suppose que le cristal soit relativement bien isolé avec par exemple des valeurs telles que $\tau_2 = 10^3$ seconde, $\theta = 10^{-3}$ seconde, $\Delta F = 3.10^6$ Hz, ce qui implique $R = 10^3$. On voit que dans ce cas, l'invention permet de porter la température du cristal à une valeur très élevée, ce qui peut être particulièrement utile pour certaines applications. Ce cas de rapport R très élevé permet également de maintenir un cristal de quartz à sa température d'inversion en dépensant une puissance infime de l'ordre par exemple de 0,1 mW, si l'on reste en régime dynamique. En effet, on peut par exemple avec un rapport $R = 10^3$ et une puissance $P_c = 10^{-1}$ mW maintenir les écarts suivants:

$$Tq_o - T_a \simeq 5.10^{-2} \ °K$$
$$Tq - T_a \simeq 50°K$$

La présente invention permet ainsi non seulement d'effectuer un chauffage ultra rapide et homogène d'un résonateur HF en le plaçant dans une cavité résonnante micro-onde du type décrit précédemment, mais encore de réaliser à l'aide de cette même cavité un thermostat à quartz fonctionnant en permanence et ne consommant pas plus que quelques milliwatts, dans la mesure où l'on réalise une modulation, par exemple en créneaux, de la fréquence du champ électrique micro-onde et où l'on isole thermiquement la cavité par rapport à l'environnement ambiant. La cavité résonnante 10 peut par exemple simplement être placée dans un boîtier étanche dans lequel on a fait le vide, de manière à réduire les pertes par rayonnement. On notera que la modulation de la fréquence du champ électrique micro-onde permet de réaliser une recherche automatique et parfaitement exacte du point d'inversion d'un cristal, ce qui limite les traînages de fréquences du résonateur HF qui sont inhérents aux autres modes de régulation des thermostats classiques pour lesquels il y a un asservissement sur une température qui n'est jamais rigoureusement la température d'inversion.

Bien entendu, diverses modifications et adjonctions peuvent être apportées aux dispositifs décrits sans sortir du cadre de l'invention. Ainsi, par exemple les plateaux définissant les électrodes 34, 35 non adhérentes au cristal 50 ne doivent pas nécessairement être réalisés en une matière conductrice. Au contraire les plateaux 34, 35 peuvent être constitués par un matériau diélectrique dont seules les faces 340, 350 situées en regard du cristal 50 ainsi que des parties des surfaces périphériques 341, 351 et des faces arrières tournées vers le matériau isolant 44, 45 sont métallisées pour réaliser des surfaces actives d'électrode 340, 350 reliées aux conducteurs de liaison 24, 25 par des chemins conducteurs déposés sur les plateaux 34, 35.

## Revendications

1. Procédé de chauffage d'un résonateur HF constitué par un cristal piézoélectrique coopérant avec au moins une paire d'électrodes excitatrices pour entrer en résonance à une fréquence $F_Q$ prédéterminée, caractérisé en ce qu'il consiste à placer l'ensemble du résonateur HF dans un champ électrique supplémentaire UHF dont la fréquence F est au moins égale à environ dix fois la fréquence de résonance $F_Q$ du résonateur.

2. Procédé selon la revendication 1, destiné à amener et maintenir le résonateur à une température prédéterminée, telle que la température d'inversion du cristal piézoélectrique, caractérisé en ce qu'il consiste à moduler en fréquence le champ électrique UHF de fréquence F, à détecter la modulation induite de la fréquence de résonance $F_Q$ du cristal piézoélectrique et à asservir la fréquence F du champ électrique UHF en fonction du signal de modulation détecté de la fréquence de résonance $F_Q$ de manière à maintenir ce signal de modulation détecté à un niveau minimum.

3. Procédé selon la revendication 2, caractérisé en ce que le champ électrique UHF est modulé à l'aide d'un signal de modulation en forme de créneaux.

4. Procédé selon l'une quelconque des revendications 1 à 3, caractérisé en ce que le cristal piézoélectrique est un cristal de quartz.

5. Dispositif de chauffage pour résonateur HF constitué par un cristal piézoélectrique (50) coopérant avec au moins une paire d'électrodes excitatrices (34, 35, 34a, 35a) produisant un champ électrique d'excitation du cristal (50) selon une fréquence de résonance $F_Q$, caractérisé en ce qu'il comprend une cavité résonnante réentrante (10) pilotant un oscillateur UHF et dimensionnée de manière à produire un champ électrique UHF de fréquence F au moins égale à 10 fois la fréquence de résonance $F_Q$ du cristal piézoélectrique (50), en ce que le résonateur HF est disposé dans l'espace compris entre l'âme centrale (14) et le fond (12) de la cavité de telle sorte que les deux électrodes (34, 35, 34a, 35a) du résonateur soient situées respectivement sensiblement dans les plans de l'extrémité libre de l'âme centrale (14), et de la face interne du fond (12) de la cavité (10), en ce que au moins l'une des électrodes (34, 35, 34a, 35a) est disposée dans un alésage (16, 15) ménagé dans les parties conductrices de la cavité selon un axe sensiblement perpendiculaire au plan du cristal (50), la partie périphérique de l'électrode étant entourée à faible distance, mais sans contact, par la paroi dudit alésage (16, 15) et en ce qu'un conducteur interne (24, 25) coaxial à l'alésage (16, 15) et isolé de celle-ci par un garnissage (44) de matériau isolant est prévu pour relier les électrodes (34, 34a) situées dans le plan de l'extrémité libre de l'âme centrale (14) à un oscillateur HF destiné à appliquer au résonateur un champ électrique de résonance à la fréquence $F_Q$.

6. Dispositif selon la revendication 5, caractérisé en ce qu'au moins l'électrode (34, 34a) du résonateur située sensiblement dans le plan de l'extrémité libre de l'âme centrale (14) est entourée à faible distance, mais sans contact par la paroi d'un alésage (16) ménagé dans l'âme centrale et définissant une partie conductrice cylindrique externe (140) isolée, à l'aide d'un garnissage (44) de matériau isolant, par rapport à un conducteur interne (24) coaxial à l'alésage (16) et reliant ladite électrode (34, 34a) à l'oscillateur HF destiné à appliquer au résonateur un champ électrique de résonance à la fréquence $F_Q$.

7. Dispositif selon la revendication 5, caractérisé en ce que l'une (35b) des électrodes (34, 35) est constituée directement par la face terminale de l'âme centrale (14) ou la face interne du fond (12) de la cavité (10) et mise à la masse de sorte qu'il est réalisé une excitation du résonateur qui est de type parallèle.

8. Dispositif selon la revendication 6, caractérisé en ce que l'électrode (35; 35a) du résonateur située sensiblement dans le plan de la face interne du fond (12) de la cavité (10) est disposée dans un logement cylindrique (15) ménagé dans le fond (12) de la cavité dans le prolongement de l'âme centrale (14), en ce que l'arête intérieure (121) du logement (15) entoure sans contact mais à faible distance l'électrode (35; 35a) située dans ledit logement (15) et en ce qu'un conducteur interne (25) coaxial à la paroi du logement cylindrique (15) et isolé de celle-ci par un garnissage (45) de matériau isolant, relie également l'électrode (35, 35a) située dans ledit logement (15) à l'oscillateur HF de manière à réaliser une excitation du résonateur qui est de type série.

9. Dispositif selon la revendication 5, la revendication 6 ou la revendication 8, caractérisé en ce que les électrodes (34a, 35a) associées au cristal piézoélectrique (50) sont solidaires des deux faces opposées du cristal (50) situées en regard respectivement de l'extrémité libre de l'âme centrale (14) et du fond (12) de la cavité (10).

10. Dispositif selon l'une quelconque des revendications 5 à 8, caractérisé en ce que les électrodes (34, 35) associées au cristal piézoélectrique (50) sont réalisées sous la forme de plateaux disposés à faible distance des deux faces opposées du cristal (50), sans contact avec celles-ci.

11. Dispositif selon l'une quelconque des revendications 5 à 8, caractérisé en ce que l'alésage interne (16) de la partie conductrice cylindrique externe (140) de l'âme centrale (14) présente du côté de l'extrémité libre de l'âme centrale (14) une partie terminale (141) qui est évasée en direction du rebord frontal (342) de la partie conductrice (140).

12. Dispositif selon l'une quelconque des revendications 5, 6 et 8 à 11, caractérisé en ce que les espaces libres ménagés entre une électrode (34, 35; 34a, 35a) et la partie conductrice de la cavité qui entoure ladite électrode à faible distance, mais sans contact, définissent une capacité dont l'impédance est faible vis à vis de la fréquence F du champ UHF mais forte vis à vis de la fréquence de résonance $F_Q$ du champ HF.

13. Dispositif selon l'une quelconque des revendications 5 à 12, caractérisé en ce que la fréquence F du champ électrique UHF est comprise entre environ 500 MHz et 10 GHz.

14. Dispositif selon l'une quelconque des revendications 5 à 13, caractérisé en ce qu'il comprend en outre des moyens de modulation de la fréquence F du champ électrique UHF, des moyens de détection de la modulation induite sur la fréquence de résonance $F_0$ du cristal et des moyens d'asservissement de la fréquence F du champ électrique UHF en fonction du signal de modulation détecté par lesdits moyens de détection pour maintenir le signal de modulation détecté en-dessous d'un niveau prédéterminé et réaliser ainsi une régulation de la température du cristal.

15. Dispositif selon l'une quelconque des revendications 5 à 14, caractérisé en ce que la cavité résonnante réentrante (10) est placée dans une enceinte étanche à l'intérieur de laquelle on a fait le vide.

16. Dispositif selon l'une quelconque des revendications 5 à 15, caractérisé en ce que l'oscillateur UHF piloté par la cavité résonnante (10) est adapté pour fournir une puissance de l'ordre de quelques centaines de milliwatts.

**Claims**

1. Fast HF resonator warm-up process consisting of a piezoelectric crystal cooperating with at least a pair of energiser electrodes to enter into resonance at a predetermined frequency FQ, characterised in that it consists in placing the HF resonator assembly in a supplementary UHF electric field whose frequency F is at least equal to around ten times the resonance frequency FQ of the resonator.

2. Process according to claim 1 designed to bring the resonator up to a predetermined temparature and maintain it there, so that the turn around temperature of the piezoelectric crystal, characterised in that it consists in frequency modulating the UHF electric field of frequency F, in detecting the induced modulation of the resonance FQ of the piezoelectric crystal and in servo-controlling the frequency F of the UHF electric field contingent on modulation signale detected of resonance frequency FQ so as to maintain this modulation signal detected at a minimum level.

3. Process, according to claim 2, characterised in that the UHF electric field is modulated via a modulated signal in gatef form.

4. Process, according to army of claims 1 to 3, characterised in that said piezoelectric crystal is a quartz crystal.

5. HF resonator micro-wave up device consisting of a piezoelectric crystal (50), cooperating with at least a pair energiser electrodes (34, 35, 34a, 35a) producing an electric field energising crystal (50) according to a resonance frequency FQ, characterised in that it comprises a re-entrant resonant cavity (10) driving a UHF oscillator and sized so as to produce a UHF electric field of frequency F well above the resonance frequency FQ of piezoelectric crystal (50), and in that the HF resonator is installed in the space between central core (14) and bottom (12) of the cavity, in such a way that said two electrodes (34, 35, 34a, 35a) of the resonator are located respectively practically in the planes of the free end of central core (14) and the internal face bottom (12) of cavity (10), and in that at least one of said electrodes (34, 35, 34a, 35a) is installed in the bore (16, 15) made in the conductor sections of the cavity along an axis practically perpendicular to the plane of the crystal (50), the peripheral section of the electrode being surrounded at a short distance, but without contact, by the wall of said bore (16, 15), and in that an internal conductor (24, 25) coaxial to the bore (16, 15) and insulated from it by a lining (44) in insulating material is provided to couple said electrode (34, 35, 34a, 35a) located in the plane of the free end the central core (14) to an HF oscillator designed to apply to the resonator a resonance electric field at frequency FQ.

6. Device according to claim 5, characterised by the fact that at least electrode (34, 34a) of the resonator located practically in the plane of the free end of the central core (14) is surrounded at a short distance, but without any contact, by the wall of a bore (16) made in the central core and defining an external cylindrical conductor section (140) insulated, via a lining (44) in insulating material, from an internal conductor (24) coaxial to the bore (16) and coupling the said electrode (34, 34a) to the HF oscillator designed to apply to the resonator a resonance electric field at frequency FQ.

7. Device, according to claim 5, characterised in that one (35b) of the electrodes (34, 35) consists directly of the terminal face of central core (14) or the internal face of the bottom (12) of cavity (10) and grounded so that it obtains energisation of the resonator which is parallel type.

8. Device, according to claim 6, characterised in that the electrode (35, 35a) of the resonator located practically in the plane of the internal face of bottom (12) of cavity (10) is installed in a cylindrical housing (15) in the bottom (12) of the cavity, in the extension of central core (14), in that the inner edge (121) of housing (15) surrounds with no contact but at short distance, the electrode (34, 35a) located in the said housing (15) and in that an internal conductor (25) coaxial to the wall of cylindrical housing (15) and isolated from it by a lining (45) in insulating material, also couples electrode (35, 35a) located in the said housing (15) to the HF oscillator so as to obtain energisation of the resonator which is of serial type.

9. Device according to claim 5, characterised in that the electrodes (34a, 35a) associated to the piezoelectric crystal (50) are integral with the two opposite faces of crystal (50) located opposite respectively the free end of central core (14) and the bottom (12) of cavity (10).

10. Device according to any of claims 5 to 8, characterised in that electrodes (34, 35) associated to piezoelectric crystal (50) are obtained in the form of plates installed at a short distance from the two opposing traces of crystal (50), without any contact with them.

11. Device according to any of claims 5 to 8, characterised in that the internal bore (16) of the external cylindrical conductor section (140) of central core (14) contains on the free end side of central core (14) a terminal section (14) which is flared in the direction of the front edge (342) of conductor section (140).

12. Device according to any of claims 5, 6 and 9 to 11 characterised in that the free spaces provided between one electrode (34, 35, 34a, 35a) and the conductor section of the cavity surrounding the said electrode at a short distance, but without any contact, define a capacitance whose impedance is low versus the frequency F of the UHF field but high versus the resonance frequency FQ of the HF field.

13. Device according to any of claims 5 to 12, characterised in that the frequency F of the UHF electric field is comprised between approximately 500 MHz and 10 GHz.

14. Device according to any of claims 5 to 13, characterised in that it comprises, in addition to the means of modulating the frequency F of the UHF electric field, means for detecting the modulation induced on the resonance frequency FQ of the crystal and means of servo-controlling the frequency F of the UHF electric field contingent on the modulation signal detected by aforesaid means of detection to maintain the modulation signal detected below a predetermined level thus obtaining regulation of the crystal temperature.

15. Device according to any of claims 5 to 14, characterised in that the re-entrant resonant cavity (10) is placed in a tight enclosure inside which a vacuum is applied.

16. Device according to any of claims 5 to 15, characterised in that the UHF oscillator driver by resonant cavity (10) is adapted to supply of power of around a few hundred milliwatts.

**Patentansprüche**

1. Heizverfahren für einen HF-Resonator bestehend aus einem Schwingkristall, der mit mindestens einem erregenden Elektrodenpaar mitwirkt, um bei einer festgelegten Frequenz $F_Q$ in Resonanz zu geraten, dadurch gekennzeichnet, dass es darin besteht, den gesamten HF-Resonator in einem zusätzlichen UHF-Kraftfeld zu setzen, dessen Eigenfrequenz F mindestens etwa zehn mal dem Wert der Schwingfrequenz $F_Q$ des Resonators entspricht.

2. Verfahren nach Anspruch 1, für das Erreichen und Einhalten einer festgelegten Resonator-Temperatur, wie z.B. die Umkehrtemperatur des Schwingkristalls, dadurch gekennzeichnet, dass es darin besteht, das UHF-Kraftfeld von Frequenz F zu modulieren, die induzierte Modulation der Schwingfrequenz $F_Q$ des Schwingkristalles zu entkoppeln und die Frequenz F des UHF-Kraftfeldes nach dem Wert des gleichgerichteten Modulationssignals der Schwingfrequenz $F_Q$ zu steuern, damit das gleichgerichtete Modulationssignal auf einem Mindestpegel gehalten werden kann.

3. Verfahren nach Anspruch 2, dadurch gekennzeichnet, dass das UHF-Kraftfeld anhand eines Modulationssignals rechtimpulsartig moduliert wird.

4. Verfahren nach einem beliebigen Anspruch 1 bis 3, dadurch gekennzeichnet, dass das der Schwingkristall aus einem Quarzkristall besteht.

5. Heizverfahren für HF-Resonator -bestehend aus einem Schwingkristall (50), der mit mindestens einem erregenden Elekrodenpaar (34, 35, 34a, 35a) zur Erzeugung eines Kraftfeldes für die Erregung des Kristalls (50) mit der Resonanzfrequenz $F_Q$ mitwirkt, dadurch gekennzeichnet, dass es aus einem für die Steuerung eines UHF-Oszillators sowie für die Erzeugung eines UHF-Kraftfeldes mit einer Frequenz F, die mindestens 10 mal dem Wert der Resonanzfrequenz $F_Q$ des Schwingkristalls (50) entspricht, ausgelegten Hohlraumresonator (10) besteht, dass der HF-Resonator im Spalt zwischen dem Kern (14) und dem Boden (12) des Hohlraumes angeordnet ist, damit die beiden Elektroden (34, 35, 34a, 35a) des Resonators genau in den Ebenen des freien Kernendes (14) bzw. der inneren Seite (12) des Hohlraumbodens (10) angeordnet sind, dass mindestens eine der Elektroden (34, 35, 34a, 35a) in einer, in den leitenden Teilen des Hohlraumresonators, nach einer senkrecht zur Kristallebene (50) Achse durchgeführten Bohrung (16, 15) angeordnet ist, wobei der Umfang der Elektrode bündig jedoch ohne Kontakt eingefasst ist, und dass ein innerer, koaxial zur Bohrung (16, 15) angeordneter und gegenüber diese Bohrung durch eine Auskleidung (44) aus nicht leitendem Werkstoff isolierter Leiter (24, 25) für die Verbindung der in der Ebene des freien Kernendes (14) angeordneten Elektroden (34, 34a) mit einem HF-Oszillator zur Erzeugung des Resonanzkraftfeldes mit der Frequenz $F_Q$ vorgesehen ist.

6. Vorrichtung nach Anspruch 5, dadurch gekennzeichnet, dass mindestens die genau in der Ebene des freien Kernendes (14) angeordnete Resonatorelektrode (34, 34a) mit geringem Abstand, jedoch ohne Kontakt, durch die Wandung einer im Kern durchgeführten Bohrung (16) umgegeben ist, wobei diese Bohrung einen äusseren leitenden zylindrischen Teil (140) darstellt, der durch eine Auskleidung (44) aus nicht leitendem Werkstoff gegenüber einem inneren, koaxial zur Bohrung (16) angeordneten Leiter (24) isoliert ist, wobei dieser Leiter die entsprechende Elektrode (34, 34a) mit dem HF-Oszillator für die Anlegung eines Resonanzkraftfeldes mit einer Frequenz $F_Q$ verbindet.

7. Vorrichtung nach Anspruch 5, dadurch gekennzeichnet, dass eine (35b) der Elektroden (34, 35) unmittelbar aus der Frontseite des Kernes (14) oder der inneren Seite des Hohlraumbodens (10) besteht und entsprechend an das Massepotential angelegt wird, damit eine parallelartige Erregung des Resonators erfolgt.

8. Vorrichtung nach Anspruch 6, dadurch gekennzeichnet, dass die genau in der Ebene der inneren Seite des Hohlraumbodens (12) angeordnete Resonatorelektrode (35, 35a) in einer zylindrischen, im Boden (12) des Hohlraumes (10) und genau gegenüber dem Kern (14) angebracht ist, dass die innere Kante (121) der Fassung (15) mit sehr geringem Abstand, jedoch ohne Kontakt, die in der erwähnten Fassung angeordnete Elektrode (35, 35a) umgibt, und dass ein innerer, koaxial zur Wandung der zylindrischen Fassung (15) angeordneter und gegenüber der Fassung durch eine Auskleidung (45) aus nicht leitendem Werkstoff isolierter Leiter die in der Fassung (15) angeordnete Elektrode (35, 35a) mit dem HF-Oszillator verbindet, damit eine reihenartige Erregung des Resonators erfolgt.

9. Vorrichtung nach Anspruch 5, Anspruch 6 oder Anspruch 8, dadurch gekennzeichnet, dass die dem Schwingkristall (50) vereinigten Elektroden (34a, 35a) fest auf den, dem freien Kernende (514) bzw. dem Boden (12) des Hohlraumes (10) gegenüberliegenden Seiten des Kristalls angeordnet sind.

10. Vorrichtung nach einem beliebigen Anspruch 5 bis 8, dadurch gekennzeichnet, dass die dem Schwingkristall (50) vereinigten Elektroden (34, 35) aus zwei Platten bestehen, die mit geringem Abstand gegenüber der gegenüberliegenden Stirnflächen des Schwingkristalles (50), jedoch ohne mit jenen in Berührung zu kommen, angeordnet sind.

11. Vorrichtung nach einem beliebigen Anspruch 5 bis 8, dadurch gekennzeichnet, dass die innere Bohrung (16) des äusseren, zylindrischen, leitenden Teils (140) des Kerns (14) auf der Seite des freien Kernendes (14) ein trichterförmiges, in Richtung der Frontkante (342) des leitenden Teils (140) geöffnetes Endstück aufweist.

12. Vorrichtung nach einem beliebigen Anspruch 5, 6 und 8 bis 11, dadurch gekennzeichnet, dass die Luftspalten zwischen einer Elektrode (34, 35, 34a, 35a) und dem leitenden Teil, der diese Elektrode in kurzer Entfernung jedoch ohne Kontakt umfasst, eine Kapazität darstellen, deren Scheinwiderstand klein gegenüber die Frequenz F des UHF-Kraftfeldes jedoch gross gegenüber der Resonanzfrequenz $F_Q$ des HF-Kraftfeldes ist.

13. Vorrichtung nach einem beliebigen Anspruch 5 bis 12, dadurch gekennzeichnet, dass die Frequenz F des UHF-Kraftfeldes zwischen ca. 500 MHz und 10 GHz liegt.

14. Vorrichtung nach einem beliebigen Anspruch 5 bis 13, dadurch gekennzeichnet, dass sie ausser Modulationsmitteln für die Frequenz F des UHF-Kraftfeldes, Gleichrichtungsmittel für die auf der Resonanzfrequenz $F_Q$ des Schwingkristalls induzierte Modulation sowie Mittel für die Steuerung der Frequenz F des UHF-Kraftfeldes nach dem Wert des gleichgerichteten Modulationssignals aufweist, damit das gleichgerichtete Modulationssignal unter einem vorgegebenen Pegel gehalten werden kann und somit eine Regelung der Temperatur des Kristalls erfolgt.

15. Vorrichtung nach einem beliebigen Anspruch 5 bis 14, dadurch gekennzeichnet, dass der Hohlraumresonator (10) in einem dichten Gefäss eingebaut wird, das luftleer gemacht wird.

16. Vorrichtung nach einem beliebigen Anspruch 5 bis 15, dadurch gekennzeichnet, dass der durch den Hohlraumresonator (10) gesteuerte UHF-Oszillator für die Abgabe einer Leistung von einigen Hunderten Milliwatt ausgelegt ist.

Fig-1

351 50 15 45 25 350 12 35 121

352

342

341

340

10

120

51

34

141

140

60

14

11

26

46

17

16

36 44 24 13

Fig-2

12 15 45 25 25a 35a 121 50

353

352

343
60

120

10

51

11

342

140

14

141 24a 16 24 34a

44

Fig-4

Fig-3

Fig. 5c

Fig. 5b

Fig. 5a